Europäisches Patentamt

European Patent Office

Office européen des brevets

(19)

(11) Numéro de publication: **0 024 227**
**B1**

(12) **FASCICULE DE BREVET EUROPEEN**

(45) Date de publication du fascicule du brevet: **13.04.83**

(51) Int. Cl.³: **H 03 K 13/09**

(21) Numéro de dépôt: **80401128.6**

(22) Date de dépôt: **30.07.80**

(54) Convertisseur analogique-numérique utilisant un dispositif à transfert de charges et une multiplication des charges.

(30) Priorité: **01.08.79 FR 7919791**

(43) Date de publication de la demande:
**25.02.81 Bulletin 81/8**

(45) Mention de la délivrance du brevet:
**13.04.83 Bulletin 83/15**

(84) Etats contractants désignés:
**DE FR GB NL**

(56) Documents cités:
**FR - A - 2 293 105**
**US - A - 4 136 335**

(73) Titulaire: **Feldmann, Michel**
**15, rue Saint Lambert**
**F-75015 Paris (FR)**

(73) Titulaire: **Godin, Jean**
**8, Avenue du Gouverneur Général Binger**
**F-94100 Saint Maur (FR)**

(73) Titulaire: **Henaff, Jeannine**
**3 ter, Place Marquis**
**F-92140 Clamart (FR)**

(72) Inventeur: **Feldmann, Michel**
**15, rue Saint Lambert**
**F-75015 Paris (FR)**
Inventeur: **Godin, Jean**
**8, Avenue du Gouverneur Général Binger**
**F-94100 Saint Maur (FR)**
Inventeur: **Henaff, Jeannine**
**3 ter, Place Marquis**
**F-92140 Clamart (FR)**

(74) Mandataire: **Mongrédien, André et al,**
**c/o BREVATOME 25, rue de Ponthieu**
**F-75008 Paris (FR)**

Courier Press, Leamington Spa, England.

### Convertisseur analogique-numérique utilisant un dispositif à transfert de charges et une multiplication des charges

La présente invention a pour objet un convertisseur analogique-numérique utilisant un dispositif à transfert de charges. Elle trouve une application dans le domaine du traitement de signal et plus particulièrement en télécommunications.

On connaît un grand nombre de dispositifs aptes à convertie une grandeur analogique (généralement une tension électrique) en un nombre (décimal ou binaire). On pourra trouver un exposé général sur ce sujet dans le numéro spécial de la revue "IEEE Transactions on Circuits and Systems" publié en Juillet 1978, vol. CAS-25, No. 7.

Parmi les convertisseurs que l'on connaît, certains font usage de dispositifs à transfert de charges. L'article de W. J. BUTLER, intitulé "Monolithic Charge Transfer A/D Converter" publié dans la revue en question aux pages 497—503, décrit par exemple un dispositif qui fonctionne de la manière suivante: un puits de potentiel étalon est rempli par un paquet de charges jusqu'à atteindre une tension de seuil; ce paquet de charges est ensuite vidé d'une quantité proportionnelle à la tension à convertir; puis il est comblé par une suite de N paquets unitaires de charges, jusqu'à obtenir à nouveau la tension de seuil. Le nombre N constitue alors une mesure numérique de la tension appliquée.

L'inconvénient de ce dispositif est évident. Aucune nouvelle conversion ne peut être entreprise avant que les N paquets de charges aient été injectés dans le puits étalon: la conversion nécessite au moins N coups d'horloge. Un tel convertisseur est donc intrinsèquement lent, comme le sont d'ailleurs tous les convertisseurs basés sur une intégration.

Or, le problème de la rapidité de la conversion analogique-numérique est l'un des plus importants en télécommunications, de sortie que ce genre de dispositif ne peut convenir en pratique, à cette application.

On connaît par ailleurs des convertisseurs analogiques-numériques qui utilisent des dispositifs à transfert de charges selon le principe différent suivant. Les charges représentant la grandeur à convertir sont déplacées sous une rangée d'électrodes, lesquelles sont couplées à des électrodes auxiliaires; les surfaces et par conséquent les capacités des puits de potentiel associés des électrodes décroissent d'un facteur 2 lorsqu'on passe d'un étage au suivant. Chaque étage effectue une division par 2 du nombre de charges qu'il reçoit de l'étage précédent, le reste de la division étant transmis à l'étage suivant. Chaque étage délivre alors un signal "1" ou "0" selon que l'électrode auxiliaire reçoit ou ne reçoit pas de charges. Ce type de convertisseur est décrit dans le brevet américain no. 3 136 335 délivré le 23 Janvier 1979 et intitulé "Semiconductor charge coupled device analog to digital converter".

L'inconvénient de ce genre de dispositif est qu'il est nécessairement limité à quelques bits (6 environ) du fait de la réduction progressive de surface des électrodes (d'un facteur 2) lorsqu'on passe d'un étage au suivant. Au-delà de 6 bits, il est très difficile de réaliser les électrodes qui ont les plus faibles dimensions.

La présente invention a justement pour objet un convertisseur analogique-numérique qui ne présente pas les inconvénients de ces deux dispositifs de l'art antérieur car il est, d'une part, très rapide et, d'autre part, il s'affranchit de ces questions de dimensions d'électrodes.

Le convertisseur de l'invention est basé sur le principe suivant. Il utilise comme étages de conversion des étages tels que ceux qui sont décrits dans le brevet américain cité plus haut, ou tout autre équivalent; mais au lieu que soient transmises d'un étage au suivant les charges constituant le reste de la division par 2 effectuée dans l'étage en question, ces charges sont multipliées au préalable par 2, de telle sorte que l'étage suivant peut être identique à l'étage précédent. Ainsi, tous les étages du convertisseur deviennent identiques, ce qui supprime l'inconvénient mentionné plus haut lié à la diminution des dimensions des électrodes. Avec le convertisseur de l'invention, le nombre de bits utilisé n'est donc plus limité supérieurement; il peut être par exemple égal à 12, ce qui est impossible avec les convertisseurs de l'art antérieur. En outre, l'identité de tous les étages simplifie grandement la fabrication du convertisseur qui devient modulaire.

Naturellement, la conversion en base 2 n'est qu'un exemple et tout autre base pourrait être utilisée, la base 10 par exemple, auquel cas le convertisseur ne serait plus binaire mais décimal.

De même, chaque étage peut comprendre plusieurs sous-étages de conversion à 1 bit, par exemple 3, auquel cas un étage fournit 3 bits selon le principe déjà connu, la multiplication des charges à la sortie d'un tel triple étage devant alors s'effectuer dans le rapport $2^3 = 8$.

De façon plus précise, l'invention a pour objet un convertisseur analogique numérique comprenant une pluralité d'étages de conversion, chaque étage comprenant un dispositif à transfert de charges constitué d'une électrode de stockage disposée à l'entrée, d'une électrode de stockage disposée à la sortie et d'électrodes auxiliaires intermédiaires, l'électrode de sortie ayant une surface K fois plus faible que l'électrode d'entrée, caractérisé en ce qu'il comprend un moyen de multiplication de charges dans un rapport K, ce moyen étant inséré entre l'électrode de sortie d'un étage et l'électrode d'entrée de l'étage suivant, et en ce que tous les étages sont identiques.

De préférence, ce convertisseur est caractérisé en ce que le rapport K est égal à 2, les électrodes intermédiaires et l'électrode de stockage disposée à la sortie possédant toutes une même surface qui est égale à la moitié de celle de l'électrode de stockage disposée à l'entrée, la conversion s'effectuant alors en binaire.

De toute façon, les caractéristiques et avantages de l'invention apparaîtront mieux après la description qui suit, d'exemples de réalisation donnés à titre explicatif et nullement limitatif. Cette description se réfère à des dessins annexés sur lesquels:

la figure 1 représente schématiquement un convertisseur à transfert de charges, selon l'invention;

la figure 2 représente une coupe schématique du convertisseur dans trois phases différentes;

la figure 3 représente une variante du convertisseur de l'invention.

La description qui suit se limitera aux moyens essentiels de l'invention et n'exposera pas les éléments constitutifs des dispositifs à transfert de charges qui sont largement connus. Pour tout détail concernant ces dispositifs, on pourra se reporter à l'ouvrage de Carlo H. SEQUIN et Michael F. TOMPSETT, intitulé "Charge transfer devices" publié en 1975 par "Academic Press, Inc.".

Pour ce qui est du dispositif d'entrée des charges dans le convertisseur, on pourra se reporter à l'article de M. F. TOMPSETT intitulé "Surface equilibration method of setting charges in CCD" publié dans la revue IEEE Transactions on Electron Devices Ed. 22, P. 305—309, juin 1975 et à l'article de C. H. SEQUIN et al intitulé "Linearity of electrical charge injection into CCD" publié dans la revue "IEEE Journal of Solid State Circuits" SC-10, p; 81—92, avril 1975.

Enfin, le convertisseur de l'invention utilise des électrodes de transfert conditionnel dont on pourra trouver une description dans l'article de R. J. HANDY intitulé "Use of CCD in the development of digital logic" publié dans la revue "IEEE Transactions on Electron Devices" Ed. 24, No. 8, Août 1977, p. 1049—1061.

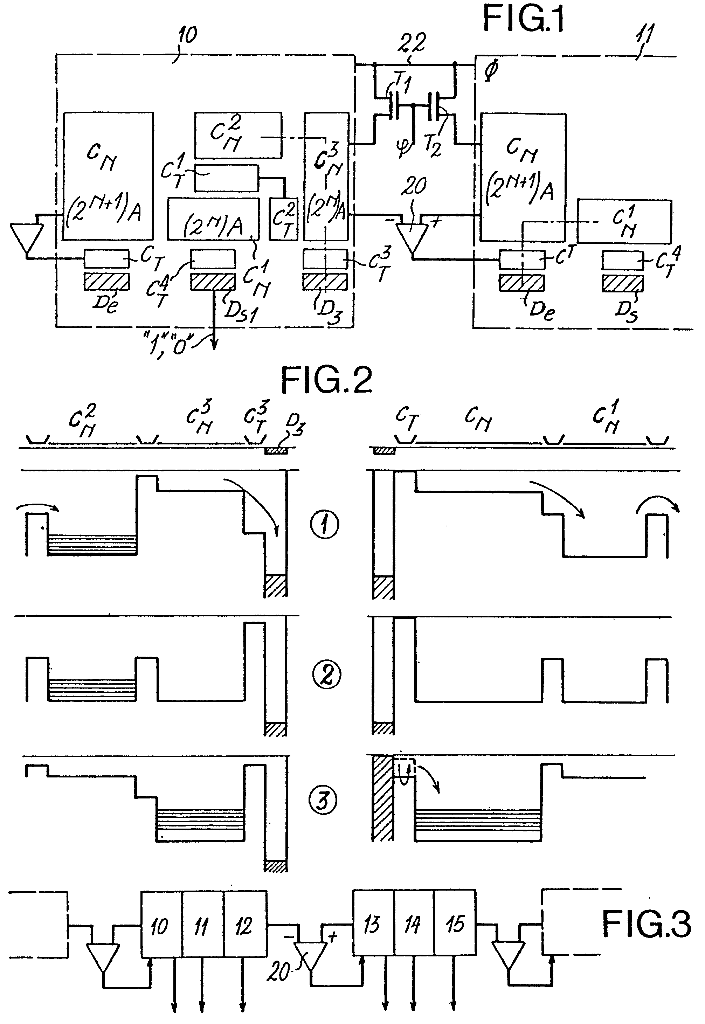

Le dispositif représenté sur la figure 1 comprent un étage de conversion 10 constitué par:

— une électrode de stockage $C_N$ de surface $2^{N+1}A$,
— une électrode de stockage $C_N^1$ de surface $2^N A$ couplée à $C_N$,
— une électrode de stockage $C_N^2$ de surface $2^N A$ séparée de $C_N^1$ par une électrode de transfert $C_T^1$,
— une électrode de stockage $C_N^3$ de surface $2^N A$ couplée à $C_N^2$ et séparée de $C_N^1$ par une électrode de transfert $C_T^2$.

L'électrode $C_N^1$ est reliée à une diode de sortie Dsl par une électrode de transfert $C_T^4$ et l'électrode $C_N^3$ à une diode $D_3$ par une électrode de transfert $C_T^3$.

Entre chaque étage de conversion (10, 11 etc...) on trouve un amplificateur différentiel 20 à deux entrées, l'une positive l'autre négative, la première étant reliée à l'électrode $C_N^2$ de l'étage qui précède et la seconde étant reliée à l'électrode $C_N$ de l'étage qui suit, et à une sortie reliée à l'électrode de transfert $C_T$ reliée à la diode d'entrée $D_e$.

Entre deux étages on trouve également deux transistors $T_1$ et $T_2$ insérés entre une ligne 22 portée à un potentiel $\Phi$ et donc les bases sont reliées entre elles et portées à un potentiel $\varphi$.

La figure 2 illustre le fonctionnement de ce dispositif et indique l'allure des tensions de surfaces observées sous diverses électrodes en fonction des potentiels qui leur sont appliquées. Le fonctionnement comprend les trois temps suivants où les signes correspondent à un dispositif où les charges transférées sont des électrons:

Temps 1:

$\varphi$ est à un potentiel élevé: les transistors $T_1$ et $T_2$ sont passants, et les électrodes $C_N^3$ et $C_N$ sont portées au potentiel $\Phi$ qui est à un niveau bas: les charges présentes sous les électrodes $C_N^3$ et $C_N$ sont déversées respectivement dans la diode $D_3$ (portée à un potentiel élevé) et sous l'électrode $C_N^1$ et éventuellement sous $C_N^2$ si la quantité de charges est supérieure à la capacité de $C_N^1$.

Temps 2:

$\Phi$ est porté à un potentiel élevé, puis revient à zéro: les transistors $T_1$ et $T_2$ sont bloqués et les électrodes $C_N^3$ et $C_N$ sont à des potentiels flottants et sont prêtes à recevoir des charges.

Pendant ces deux temps, les électrodes $C_N^3$ d'un étage et $C_N$ de l'étage suivant restent au même potentiel, et l'amplificateur 20 impose une tension nulle sur $C_T$; la diode $D_e$ est portée à un potentiel élevé.

Temps 3:

Les charges contenues sous $C_N^3$ sont transférées sous $C_N^3$ et éventuellement celles sous $C_N'$ (transfert conditionnel à travers $C_T^2$). Ces charges induisent sur l'électrode flottante une variation de potentiel $\Delta$ négative, proportionnelle à cette charge, et inversement proportionnelle à la surface de l'électrode. L'amplificateur 20 induit en conséquence une tension positive sur $C_T$, permettant l'injection de charges depuis la diode $D_e$ (portée à la masse) sous l'électrode $C_N$. Le potentiel flottant de cette électrode diminue tant que des charges arrivent. Quand le potentiel de $C_N$ a rejoint celui de $C_N^3$, la tension appliquée sur $C_T$ est revenue à zéro, bloquant ainsi l'injection des charges sous $C_N$. Les quantités de charges sous $C_N$ et $C_N^3$ sont dans le même rapport que celui des surfaces de ces électrodes (ici 2): il y a eu doublement des charges entre l'étage 10 et l'étage 11.

Lorsque la quantité de charges présente sous $C_N$ est inférieure à la capacité du puits situé sous $C_N^1$ le signal délivré par Ds est nul et le bit correspondant à cet étage est égal à "0". Si cette quantité est au contraire supérieure à cette capacité, le bit est à "1". Le transfert de $C_N^1$ vers $C_N^3$ est conditionnel; il n'est effectué que dans le premier cas; dans le second tout le puits est vidé par Ds et seules les charges de $C_N^2$ sont transférées à $C_N^3$, $C_T^1$ bloquant $C_T^2$. Le processus se poursuit ainsi d'étage en étage.

En résumé, chaque étage effectue une division par 2 des charges qu'il reçoit (ou une "pesée" de ces charges), le reste de la division étant ensuite multiplié par 2 lors de son transfert à l'étage suivant.

L'amplificateur 20 peut être situé à une place quelconque, mais il est de préférence intégré au dispositif à transfert de charges. Naturellement, l'invention ne se limite pas à l'emploi d'un amplificateur opérationnel, mais s'étend, au contraire, à tout dispositif susceptible de remplir la fonction de multiplication de charges, ou plus généralement à tout dispositif capable d'asservir les deux potentiels des électrodes à l'aide d'une injection de charges.

La figure 3 illustre un convertisseur dans lequel chaque étage de conversion est à 3 bits, et est formé de 3 sous-étages (10, 11, 12) ou (13, 14, 15) ... chacun conforme à l'étage 10 de la figure 1. L'amplificateur multiplicateur de charge 20 est placé entre chaque triple étage. Un tel convertisseur délivre des multiplets de 3 bits.

**Revendications**

1. Convertisseur analogique numérique comprenant une pluralité d'étages de conversion (10, 11), chaque étage comprenant un dispositif à transfert de charges constitué d'une électrode de stockage disposée à l'entrée ($C_N$), d'une électrode de stockage disposée à la sortie ($C_N^3$) et d'électrodes auxiliaires intermédiaires ($C_N^1$, $C_N^2$), l'électrode de sortie ayant une surface K fois plus faible que l'électrode d'entrée, caractérisé en ce qu'il comprend un moyen de multiplication de charges (20, De) dans un rapport K, ce moyen étant inséré entre l'électrode de sortie d'un étage et l'électrode d'entrée de l'étage suivant, et en ce que tous les étages sont identiques.

2. Convertisseur selon la revendication 1, caractérisé en ce que le rapport K est égal à 2, les électrodes intermédiaires et l'électrode de stockage disposée à la sortie possédant toutes une même surface qui est égale à la moitié de celle de l'électrode de stockage disposée à l'entrée, la conversion s'effectuant alors en binaire.

3. Convertisseur selon la revendication 2, caractérisé en ce qu'il comprend:

—une électrode de stockage $C_N$ de surface $2^{N+1}A$,

—une électrode de stockage $C_N^1$ de surface $2^N A$ couplée à $C_N$,

—une électrode de stockage $C_N^2$ de surface $2^N A$ séparée de $C_N^1$ par une électrode de transfert $C_T^1$,

—une électrode de stockage $C_N^3$ de surface $2^N A$ couplée à $C_N^2$ et séparée de $C_N^1$ par une électrode de transfert $C_T^2$.

4. Convertisseur selon la revendication 3, caractérisé en ce que le moyen de multiplication de charges est un circuit amplificateur à deux entrées, l'une positive l'autre négative, la première étant reliée à l'électrode $C_N^2$ de l'étage qui précède et la seconde étant reliée à l'électrode $C_N$ de l'étage qui suit, et à une sortie reliée à une électrode de transfert $C_T$ reliée à une diode d'entrée $D_e$.

**Patentansprüche**

1. Analog-Digitalwandler mit einer Anzahl von Wandlerstufen, jeweils bestückt mit einer Einrichtung für die Übertragung von Ladungen, welche eine am Eingang (CN) angeordnete Speicherelektrode, eine am Ausgang (CN³) angeordnete Speicherelektrode und dazwischen angeordnete Hilfselektroden (CN¹, CN²) aufweist, wobei die Oberfläche der Ausgangselektrode K mal geringer ist als die der Eingangselektrode, dadurch gekennzeichnet, daß er eine Einrichtung für die Multiplikation von Ladungen (20, De) um den Faktor K aufweist, welche zwischen der Ausgangselektrode einer Stufe und der Eingangselektrode der folgenden Stufe angeordnet ist, und daß sämtliche Stufen miteinander identisch sind.

2. Wandler nach Anspruch 1, dadurch gekennzeichnet, daß der Faktor K glwich 2 ist, und daß die zwischengeordneten Elektroden sowie die am Ausgang angeordnete Speicherelektrode sämtlich eine gleiche Oberfläche aufweisen, welche gleich der Hälfte derjenigen der am Eingang angeordneten Speicherelektrode ist, so daß die Wandlung binär erfolgt.

3. Wandler nach Anspruch 2, dadurch gekennzeichnet, daß er

eine Speicherelektrode CN mit einer Oberfläche $2^{N+1}A$,

eine mit CN gekoppelte Speicherelektrode CN¹ mit einer Oberfläche $2^N A$,

eine durch eine Übertragungselektrode CT¹ von der Elektrode CN¹ getrennte Speicherelektrode CN² mit einer Oberfläche $2^N A$,

und eine mit der Elektrode CN² gekoppelte und durch eine Übertragungselektrode CT² von der Elektrode CN¹ getrennte Speicherelektrode CN³ mit einer Oberfläche $2^N A$ aufweist.

4. Wandler nach Anspruch 3, dadurch gekennzeichnet, daß die Einrichtung für die Multiplikation von Ladungen ein Verstärkerkreis mit zwei Eingängen, nämlich einem positiven und einem negativen, ist, von denen der erste mit der Elektrode CN² der voraufgehenden Stufe und der andere mit der Elektrode CN der folgenden Stufe verbunden ist, und daß ein Ausgangs des Verstärkerkreises mit einer Übertragungselektrode CT verbunden ist, welche ihrerseits mit einer Eingangsdiode De verbunden ist.

## Claims

1. Analogue-digital converter comprising a plurality of conversion stages (10, 11), each stage comprising a charge-transfer device comprising a storage electrode ($C_N$) located at the input, a storage electrode ($C_N^3$) located at the output, and intermediate auxiliary electrodes ($C_N^1$, $C_N^2$), the output electrode having a surface K times less than that of the input electrode, characterized in that it comprises a device (20, $D_e$) for multiplying charges in a ratio K, said device being located between the output electrode of one stage and the input electrode of the following stage, and in that all the stages are identical.

2. Converter according to claim characterized in that the ratio K=2, the intermediate electrode and the storage electrode located at the output each having an identical surface equal to half that of the storage electrode located at the input, conversion thereby being effected into binary.

3. Converter according to claim 2 characterized in that it comprises:

— a storage electrode $C_N$ of surface $2^{N+1}A$,
— a storage electrode $C_N^1$ of surface $2^N A$ coupled to $C_N$,
— a storage electrode $C_N^2$ of surface $2^N A$ separated from $C_N^1$ by a transfer electrode $C_T^1$, and
— a storage electrode $C_N^3$ of surface $2^N A$ coupled to $C_N^2$ and separated from $C_N^1$ by a transfer electrode $C_T^2$.

4. Converter according to claim 3 characterized in that the charge multiplication device is an amplifying circuit with two inputs, one positive and the other negative, the first being connected to electrode $C_N^2$ of the preceding stage, and the second being connected to electrode $C_N$ of the following stage, and one output connected to a transfer electrode $C_T$ connected to an input diode ($D_e$).

# FIG.1

# FIG.2

# FIG.3